Europäisches Patentamt

European Patent Office

Office européen des brevets

(19)

(11) EP 1 406 477 A1

(12) **EUROPEAN PATENT APPLICATION**
published in accordance with Art. 158(3) EPC

(43) Date of publication:
07.04.2004 Bulletin 2004/15

(51) Int Cl.⁷: **H05K 3/46**

(21) Application number: 01974745.0

(86) International application number:
PCT/JP2001/008860

(22) Date of filing: 09.10.2001

(87) International publication number:
WO 2003/009661 (30.01.2003 Gazette 2003/05)

(84) Designated Contracting States:
**AT BE CH CY DE DK ES FI FR GB GR IE IT LI LU MC NL PT SE TR**

(30) Priority: 12.07.2001 JP 2001212211

(71) Applicant: **MEIKO ELECTRONICS CO., LTD.**
**Ayase-shi, Kanagawa 252-1104 (JP)**

(72) Inventors:
• **MITSUHASHI, Takayuki,**
**c/o MEIKO ELECTRONICS CO LTD**
**Ayase-shi, Kanagawa 252-1104 (JP)**

• **KATAGIRI, Yasuyuki,**
**c/o MEIKO ELECTRONICS CO. LTD.**
**Ayase-shi, Kanagawa 252-1104 (JP)**
• **MATSUDA, Takahiro,**
**c/o MEIKO ELECTRONICS CO., LTD.**
**Ayase-shi, Kanagawa 252-1104 (JP)**
• **KANDA, Takeshi,**
**c/o MEIKO ELECTRONICS CO., LTD.**
**Ayase-shi, Kanagawa 252-1104 (JP)**

(74) Representative: **Modiano, Guido, Dr.-Ing. et al**
**Modiano, Josif, Pisanty & Staub,**
**Baaderstrasse 3**
**80469 München (DE)**

(54) **CORE SUBSTRATE&comma; AND MULTILAYER CIRCUIT BOARD USING IT**

(57) A core substrate (B) for being used in producing a multilayer circuit board in a manner that a plurality of unit circuit boards are laid on the upper and lower surfaces of the core substrate comprises two insulation layers (10A, 10B) laid with a conductor land part (11A) between. The insulation layers have a pair of laser-machined holes (12A, 12B) above and below the conductor land part, each extending from the surface of the insulation layer up to the conductor land part. The pair of laser-machined holes are filled with an electroplating material to form a pair of columnar conductors (13A, 13B) electrically connected through the conductor land part. Since all layers can be interconnected through a series structure formed of an electro copper plating material, the core substrate is useful for producing a multilayer circuit board in which low resistance and fine patterning can be realized.

FIG. 8

EP 1 406 477 A1

**Description**

**TECHNICAL FIELD**

The invention relates to a core substrate for use in producing a multilayer circuit board by a buildup process, and a multilayer circuit board using it. More specifically, the invention relates to a core substrate for use in producing a multilayer circuit board which provides high reliability of electrical interconnection between layers, allows fine circuit patterning, and thus, enables high-density mounting of components and reduction of the overall size, and a multilayer circuit board using it.

**BACKGROUND ART**

In recent years, with the development of miniaturization, multifunctioning and weight saving of electronic/electrical devices, multilayer circuit boards have come into use widely as circuit boards used in those devices. The multilayer circuit board is an integrated structure in which a plurality of unit circuit boards, each having a conductor circuit formed in a predetermined pattern on a surface thereof, are laid in layers. The unit circuit boards are electrically interconnected through through-holes or via-holes.

As a demand for a fine conductor circuit and high-density circuit patterning is increasing, a buildup process is becoming an almost single major way of producing a multilayer circuit board.

Referring to the attached drawings, an example of the buildup process will be described below.

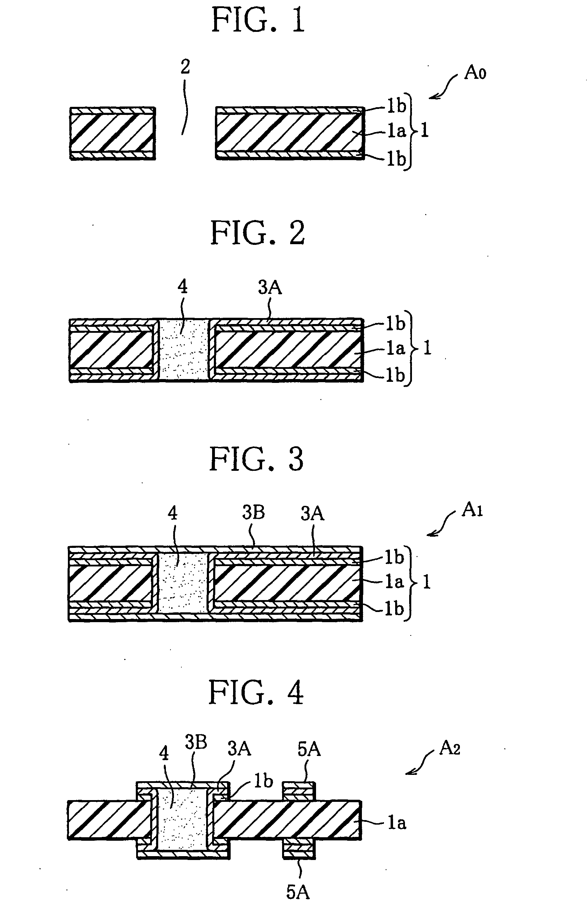

First, as shown in FIG. 1, a double-sided copper-clad laminate 1, in which copper foils 1b, 1b are attached on the opposite surfaces of an insulation base material 1a, is prepared as a core substrate $A_0$, and a through-hole (drilled hole) 2 of a predetermined diameter is drilled in the core substrate $A_0$ at a predetermined position.

Next, as shown in FIG. 2, copper plating 3A is formed by performing electroless copper plating and electro copper plating in this order. Then, the drilled hole 2 is filled with a filling material 4 such as conductive paste or epoxy resin, and dried. Then, the surface of the whole is polished so that the filling material 4 will be flush with the copper plating 3A.

Next, surface-roughening, electroless copper plating and electro copper plating are performed on the surface of the whole in this order, to form an intermediate material $A_1$ in which, as shown in FIG. 3, the filling material 4 is covered with copper plating 3B on its upper and lower surfaces.

Next, patterning and then etching, for example, using ferrous chloride are performed on the intermediate material $A_1$ to form an intermediate material $A_2$ in which, as shown in FIG. 4, conductor circuits 5A are formed on the opposite surfaces of the insulation substrate 1a in a predetermined pattern. The conductor circuits 5A, 5A formed on the opposite surfaces are electrically connected through the filling material 4 and the copper plating 3A.

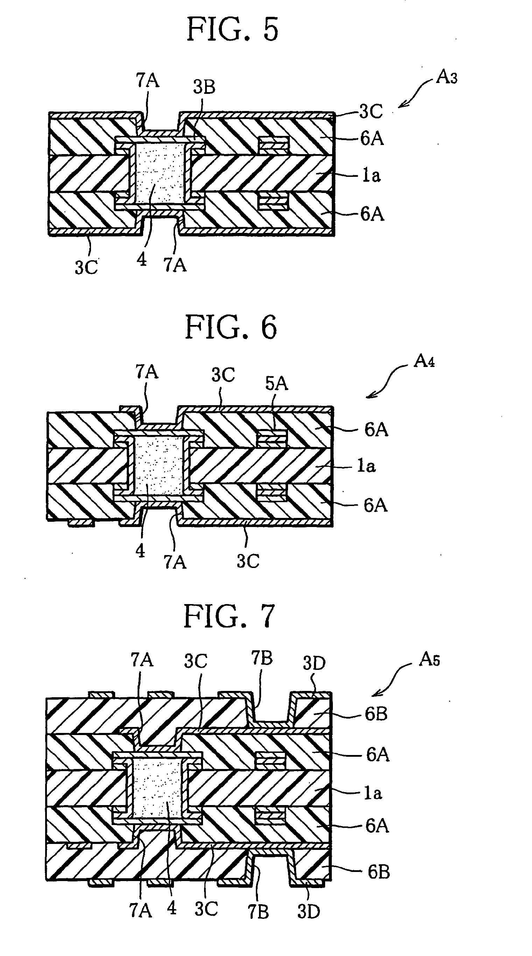

Next, as shown in FIG. 5, insulation layers 6A, 6A are laid so that the conductor circuits will be buried in the insulation layers, and then hot-pressed. Then, for example, by performing laser beam machining onto a predetermined part of each insulation layer, a concave hole 7A for a via-hole, which extends up to the copper plating 3B, is formed. Then, surface-roughening, electroless copper plating and electro copper plating are performed on the surface of each insulation layer 6A in this order, to form an intermediate material $A_3$ in which copper plating 3C is formed to cover the entire surface of each insulation layer 6A and each copper plating 3B.

Next, as shown in FIG. 6, patterning and etching are performed on the copper plating 3C of the intermediate material $A_3$ to form an intermediate material $A_4$ in which a conductor circuit is formed on the surface of each of the insulation layers 6A, 6A in a predetermined pattern.

Then, the process for forming an intermediate material $A_3$ from an intermediate material $A_2$ is performed on the intermediate material $A_4$ to lay an insulation layer 6B over (under) the insulation layer 6A, form a concave hole 7B for a via-hole in the insulation layer 6B, and form a conductor circuit formed of copper plating 3D in a predetermined pattern. Thus, as shown in FIG. 7, a multilayer circuit board $A_5$ having a five-layer structure as a whole is produced.

The above-described buildup process has the following problems:

(1) First, in producing a core substrate $A_0$, a through-hole 2 needs to be drilled in a double-sided copper-clad laminate 1.

Regarding recent multilayer circuit boards, however, further reduction in size and thickness, and denser and finer circuit patterning are demanded, which requires further reduction in diameter of the through-hole 2. Recently, the diameter of the drilled hole is reduced to about 0.10 to 0.15mm.

However, forming a through-hole so small in diameter needs an expensive minuscule drill. Also, there are problems such that a drill breaks frequently, that the accuracy of the through-hole position lowers, and that the drilling speed lowers. Thus, it is very difficult to meet a demand for low production cost.

(2) The drilled through-hole needs to be filled with conductive paste or the like. However, filling a minuscule-diameter hole with resin or conductive paste perfectly is not only very difficult, but also requires installation of equipment and addition of steps for performing such filling. Thus, the overall production cost increases.

(3) As seen from the multilayer circuit board $A_5$

shown in FIG. 7, a via-hole 7B in an insulation layer 6B is never formed right above a via-hole 7A in an insulation layer 6A located just under the insulation layer 6B. The reason is, when the insulation layer 6B is laid, the via-hole 7A is in the shape of a concave hole, and hence, it is impossible to form a via-hole 7A above the via-hole 7A.

Thus, the via-hole 7B in the insulation layer 6B has to be formed two-dimensionally away from the via-hole 7A. This means, however, that the distribution of via-holes in one plane of the multilayer circuit board $A_5$ cannot be dense. This is unfavorable for the intended high-density mounting of components.

In order to form a via-hole 7B right above the via-hole 7A, it is necessary to fill the via-hole 7A, for example, with conductive paste, form a copper layer to cover the via-hole 7A filled with the conductive paste, and then form a via-hole 7B above the copper layer. Thus, steps are added and production cost increases.

A multilayer circuit board which intends to deal with such problems has recently gone on the market (ALIVH (registered trademark) produced by Matsushita Electronic Components Co., Ltd.). This multilayer circuit board is produced as follows: A hole for a via-hole is laser-machined in a sheet of prepreg made of aramid nonwoven fabric and epoxy resin. The laser-machined hole is filled with conductive paste. Then, copper foil is laid over the entire surface of the prepreg sheet and hot-pressed. Then, a plurality of prepreg sheets, which are made of the same materials and each have a predetermined conductor circuit formed thereon, are stacked in order, and last, hot-pressed.

In the case of this multilayer circuit board, drilling is not performed, and no through-holes are formed. Regarding all the layers, interlaminar connection is formed between a via-hole filled with conductive paste and a via-land formed on each layer. Interlaminar connection can be formed even right below a component land. However, also in this multilayer circuit board, the laser-machined hole needs to be filled with conductive paste, hence, the problem (2) remains unsolved.

Further, in this prior technique, regarding all the layers, interlaminar connection is formed by conductive paste. However, forming interlaminar connection by conductive paste has problems mentioned below.
(4) Generally, the value of resistance of conductive paste is higher than that of copper or the like used, for example, for through-hole plating. In addition, since the conductive paste is a mixture of copper powder or silver powder and resin, the coefficient of thermal expansion of the conductive paste is larger than that of a copper plating material.

Hence, if, regarding all the layers, interlaminar connection is formed by the conductive paste, the larger the number of the layers, the higher the value of overall resistance of interlaminar connection becomes. Also, thermal stress is produced. Due to these and others problems, the circuit board reliability lowers.
(5) Interlaminar connection by conductive paste is formed only by contact bonding between the conductive paste filling the laser-machined hole and the via-land located right over (under) the conductive paste.

Thus, bonding strength between them cannot be always high. Thus, in order to increase the bonding strength between them, it is necessary to enlarge the diameter of the laser-machined hole as well as the diameter of the via-land.

However, this is against the trend toward miniaturization of a via-land and finer patterning of a conductor circuit, and hence unfavorable.

Another multilayer circuit board using another prior technique regarding the buildup process is also sold on the market ($B^2$it™ produced by Toshiba Corporation). This multilayer circuit board is produced as follows: A mountain-shaped projecting bump is formed by printing an intended figure on copper foil with silver paste and drying it. Then, prepreg is placed over this so that the bump will pass through the prepreg and come in contact with a copper pad on an upper layer.

In this case, however, interlaminar connection is formed by contact bonding between the conductive paste and the copper foil. Hence, like the above-mentioned ALIVH (registered trademark), there seem to be problems such that the value of electrical resistance increases, and that the reliability of connection against heat and physical impact is not enough.

An object of the invention is to provide a novel core substrate useful for producing a multilayer circuit board which can solve all the above problems (1) to (5) found in the prior art, and a novel multilayer circuit substrate using it.

## DISCLOSURE OF THE INVENTION

In order to achieve the above object, the invention provides a core substrate for being used in producing a multilayer circuit board in a manner that a plurality of unit circuit boards are laid on the upper and lower surfaces of the core substrate, comprising

two insulation layers laid with a conductor land part between, the insulation layers having a pair of laser-machined holes above and below the conductor land part, each extending from the surface of the insulation layer up to the conductor land part, and the pair of laser-machined holes being filled with an electroplating material to form a pair of columnar conductors electrically connected through the conductor land part (this core substrate will be hereinafter referred to as "core substrate B").

The invention also provides a core substrate for being used in producing a multilayer circuit board in a manner that a plurality of unit circuit boards are laid on the upper and lower surfaces of the core substrate, comprising

an insulation layer with a conductor land part on one of the opposite surfaces thereof, the insulation layer having a laser-machined hole extending from the other of the opposite surfaces of the insulation layer up to the conductor land part, the laser-machined hole being filled with an electroplating material to form a columnar conductor, and a conductor circuit being formed on each of the opposite surfaces of the insulation layer in an area where the columnar conductor is not formed (this core substrate will be hereinafter referred to as "core substrate C").

The invention further provides a multilayer circuit board comprising a plurality of unit circuit boards laid in successive layers on the upper and lower surfaces of an above-described core substrate B or C,

each of the unit circuit boards having a laser-machined hole located right above the columnar conductor of the core substrate, and all the laser-machined holes being filled with an electroplating material to form an alignment of via-structures where the lower surface of an upper via-structure is in contact with the upper surface of a lower via-structure.

The invention also provides a multilayer circuit board comprising a plurality of unit circuit boards laid in successive layers on the upper and lower surfaces of an above-described core substrate B or C,

each of the unit circuit boards having a laser-machined hole located right above the columnar conductor of the core substrate, all the laser-machined holes being filled with an electroplating material to form an alignment of via-structures where the lower surface of an upper via-structure is in contact with the upper surface of a lower via-structure, and only the uppermost via-structure having an open wrinkle structure.

## BRIEF DESCRIPTION OF THE DRAWINGS

FIG. 1 is a cross-sectional view of an example $A_0$ of a double-sided copper-clad laminate in which a hole is drilled,

FIG. 2 is a cross-sectional view of the double-sided copper-clad laminate in a state that the drilled hole is plated with copper and filled with conductive paste,

FIG. 3 is a cross-sectional view of an intermediate material $A_1$ where the conductive paste is covered with plating,

FIG. 4 is a cross-sectional view of an intermediate material $A_2$,

FIG. 5 is a cross-sectional view of an intermediate material $A_3$,

FIG. 6 is a cross-sectional view of an intermediate material $A_4$,

FIG. 7 is a cross-sectional view of a conventional multilayer circuit board $A_5$ having a five-layer structure,

FIG. 8 is a cross-sectional view of an example B of a core substrate according to the invention,

FIG. 9 is a cross-sectional view of a double-sided copper-clad laminate used for producing the core substrate B,

FIG. 10 is a cross-sectional view of an intermediate material $B_2$ where a conductor land part is formed,

FIG. 11 is a cross-sectional view of an intermediate material $B_3$,

FIG. 12 is a cross-sectional view of an intermediate material $B_4$ where an opening is formed in each surface,

FIG. 13 is a cross-sectional view of an intermediate material $B_5$ where a pair of holes are laser-machined,

FIG. 14 is a cross-sectional view of an intermediate material $B_6$ where a pair of columnar conductors are formed,

FIG. 15 is a cross-sectional view for explaining a filling rate at which a laser-machined hole is filled with a columnar conductor,

FIG. 16 is a cross-sectional view of a multilayer circuit board (intermediate material $b_1$) formed using a core substrate B,

FIG. 17 is a cross-sectional view of a multilayer circuit board (intermediate material $b_2$) formed using a core substrate B,

FIG. 18 is a cross-sectional view of an example of a multilayer circuit board having a six-layer structure using a core substrate B,

FIG. 19 is a cross-sectional view of an example C of another core substrate according to the invention,

FIG. 20 is a cross-sectional view of a double-sided copper-clad laminate in a state that a part intended to be a conductor land part is formed for producing the core substrate C,

FIG. 21 is a cross-sectional view of the double-sided copper-clad laminate in a state that a hole is laser-machined,

FIG. 22 is a precursor $C_0$ of the core substrate C, and

FIG. 23 is a multilayer circuit board produced using the core substrate C.

## BEST MODE OF CARRYING OUT THE INVENTION

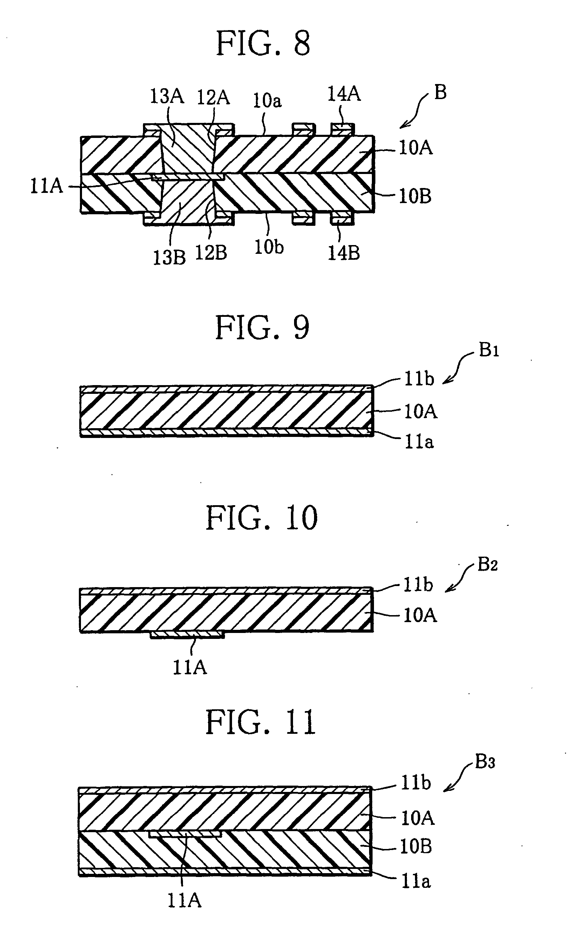

FIG. 8 shows an example of a core substrate B according to the invention.

In the core substrate B, two insulation layers 10A, 10B are laid, and a conductor land part 11A (described later) is held at the interface between the two insulation layers 10A, 10B. Thus, if the conductor land part 11A is counted as one layer, the core substrate B as a whole has a three-layer structure.

Above the conductor land part 11A, a hole 12A (described later) is laser-machined, which extends from the surface 10a of the insulation layer 10A up to the conductor land part 11A. Below the conductor land part 11A, a hole 12B (described later) is laser-machined, which extends from the surface 10b of the insulation layer 10B up to the conductor land part 11A.

The laser-machined holes 12A, 12B are filled with, for example, copper by electroplating (described later), so that columnar conductors 13A, 13B are formed in the laser-machined holes 12A, 12B, one above the other, sharing the conductor land part 11A. On the respective surfaces of the insulation layers 10A, 10B are formed conductor circuits 14A, 14B in a predetermined pattern.

Hence, in the core substrate B, the columnar conductors 13A, 13B are electrically connected through the conductor land part 11A. The core substrate B is used in the manner that unit circuit boards are laid in successive layers on the upper surface 10a and the lower surface 10b of the core substrate B.

The core substrate B is produced as follows:

First, as shown in FIG. 9, a double-side copper-clad laminate $B_1$ comprising an insulation layer 10A is prepared, where the insulation layer 10A may be of, for example, epoxy resin of FR-4 or higher, a material containing glass cloth in addition to the epoxy resin, an organic insulating material such as polyimide resin, bismaleimide triazine resin or polyphenylene ether resin, or a material containing glass cloth, organic fiber or inorganic fiber in addition to the organic insulating material as mentioned above, and have a thickness of 30 to $200\mu m$, desirably about $50\mu m$.

Onto the opposite surfaces of the insulation layer 10A, copper foils 11a, 11b having a thickness of 9 to $35\mu m$, desirably about $18\mu m$ are pressed.

Patterning and etching are performed only on the copper foil 11a on one side of the double-sided copper-clad laminate $B_1$, to leave a conductor land part 11A at a desired place on the surface of the insulation layer 10A and remove the other part of the copper foil by etching, to thereby form an intermediate material $B_2$ (FIG. 10).

It is desirable that the size of the conductor land part 11A in the intermediate material $B_2$ is larger than the opening diameter of a laser-machined hole (described later) by $100\mu m$ or more.

Next, on that surface of the intermediate material $B_3$ on which the conductor land part 11 A is formed, an insulation layer 10B of prepreg and a copper foil 11a are laid in this order. Then, the whole is hot-pressed so that the insulation layer 10B will be heat-cured.

As a result, an intermediate material $B_3$ where the conductor land part 11A is held at the interface between the two insulation layers 10A, 10B as shown in FIG. 11 is formed.

The insulation layer 10B used in this process may be of prepreg of epoxy resin or prepreg containing glass cloth in addition to epoxy resin, and have a thickness of 30 to $100\mu m$, desirably $50\mu m$. The copper foil 11a may have a thickness of 9 to $35\mu m$, desirably $18\mu m$.

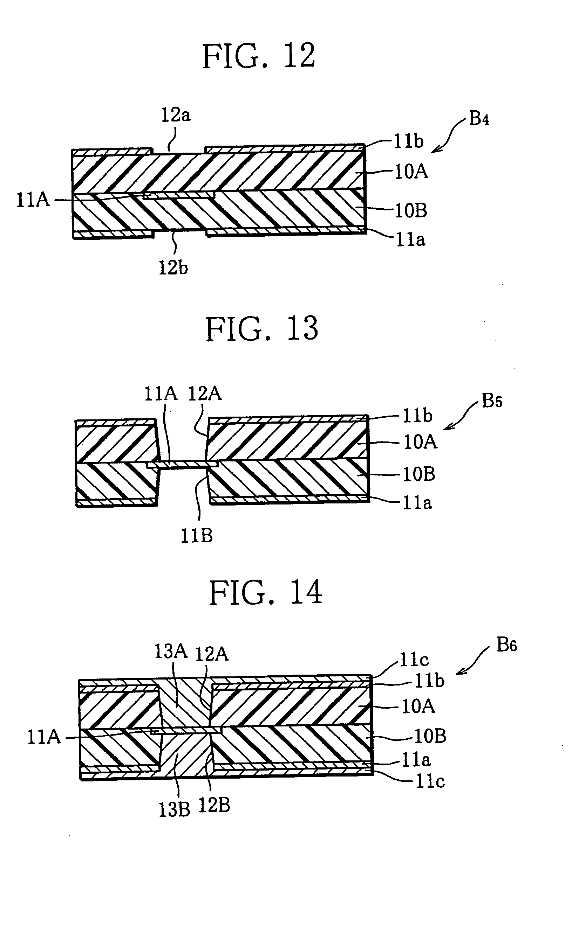

Next, patterning and etching are performed on the copper foils 11a, 11b of the intermediate material $B_3$, to remove from them only a part right above the conductor land part 11A and a part right below the conductor land part 11A by etching, to thereby form an intermediate material $B_4$ having openings 12a, 12b as shown in FIG. 12.

The openings 12a, 12b are provided for applying a laser beam to the insulation layers 10A, 10B through them to laser-machine holes 12A, 12B in the insulation layers 10A, 10B. The diameter of the openings 12a, 12b needs to be larger than the diameter of the holes to be laser-machined. Normally, it is desirable that the diameter of the openings 12a, 12b is larger than the spot diameter of the laser beam by about 50 to $150\mu m$.

Next, a laser beam is applied to the insulation layers 10A, 10B through the openings 12a, 12b formed in the opposite surfaces of the intermediate material $B_4$, to laser-machine a hole 12A extending up to the upper surface of the conductor land part 11A and a hole 12B extending up to the lower surface of the conductor land part 11A, respectively, to thereby form an intermediate material $B_5$ shown in FIG. 13. Considering the shape of columnar conductors formed by electro copper plating (described later), it is desirable that the size of the laser-machined holes is 50 to $200\mu m$.

The used laser beam may be of a carbon dioxide laser, a YAG laser, an excimer laser or the like. Considering the laser beam is applied to the opposite sides of the conductor land part 11A, the carbon dioxide laser is optimal to prevent damage of the conductor land part 11A.

Next, the laser-machined holes 12A, 12B of the intermediate material $B_5$ are filled with an electro copper plating material to form columnar conductors 13A, 13B whose respective bottoms are in contact with the conductor land part 11A. Also the copper foils 11a, 11b are covered with copper plating 11c, to thereby form an intermediate material $B_6$ shown in FIG. 14.

Specifically, first, desmearing is performed by spraying, for example, permanganate to thereby remove a film remaining on the surface of the conductor land part 11A, and the wall surfaces of the laser-machined holes 12A, 12B are roughened. Then, electroless copper plating is performed to impart electroconductivity to the wall surfaces of the insulation layers and the surfaces of the copper foils 11a, 11b, and then electro copper plating (described later) is performed to form columnar conductors.

As described later, above the columnar conductors 13A, 13B, via-holes of a to-be-produced multilayer circuit board need to be formed in order, to thereby form a series via-structure. Hence, the respective surfaces of the columnar conductors 13A, 13B need to be as flat as possible.

Generally, depending on the opening diameter, or the top diameter of the laser-machined holes 12A, 12B and the depth thereof, the electro copper plating material (columnar conductors) which fills the laser-machined holes 12A, 12B can cave in. In that case, normally, the electro copper plating material which fills the laser-machined hole is most caved at its central part.

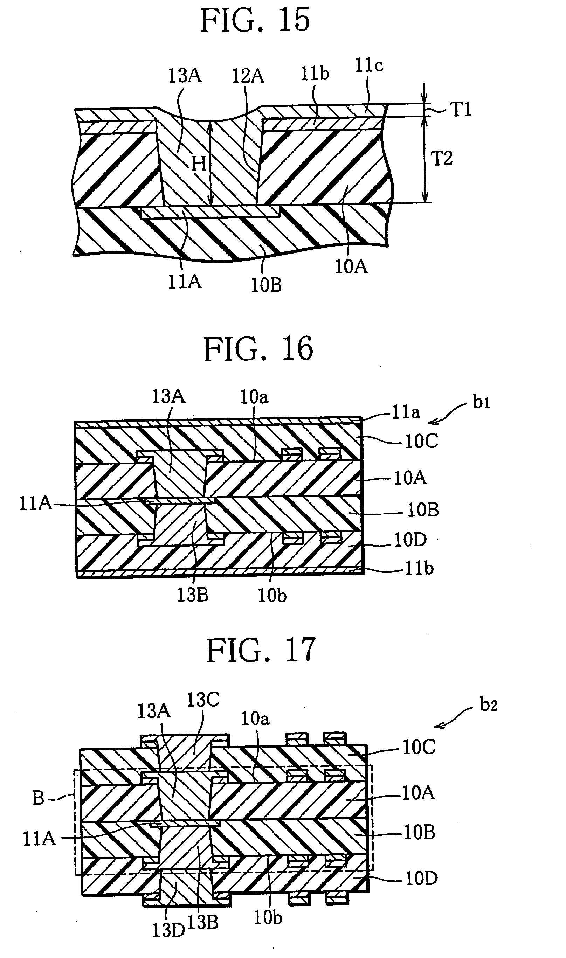

FIG. 15 shows how it is.

Here, the columnar conductor 13A shown in FIG. 15 needs to be formed into a shape in which the filling rate (%) represented by the expression

$$100 \times H/(T_1 + T_2)$$

is 70% or higher, where $T_2$ is the thickness from the interface between the lower insulation layer 10B and the upper insulation layer 10A to the upper surface of the copper foil 11b on the insulation layer 10A, $T_1$ the thickness of the copper layer 11c formed on the copper foil 11b by electro copper plating, H the distance from the most caved part (central part) of the columnar conductor 13A to the upper surface of the conductor land part 11A (which is the interface of the two insulation layers).

When the filling rate is high, it means that the smallest filling thickness H of the electro copper plating material (columnar conductor) is large, which means that the upper surface of the columnar conductor 13A is close to being flush with the copper layer 11c. When the filling rate is 70% or higher, via-holes can be formed in circuit boards (not shown) laid over the columnar conductor, directly. The desirable filling rate is 80% or higher.

Desirable electro copper plating performed for forming a columnar conductor having the above filling rate is as follows:

First, as a desirable copper plating bath, a copper plating bath which has a bath composition containing 170 to 240g/L of copper sulfate, 30 to 80g/L of sulfuric acid, and 20 to 60mg/L of chlorine ion, and to which, for example, CUBELITE VF-II (name of a product by EBARA-UDYLITE CO., LTD.) is added as an additive can be used.

It is desirable to set the bath temperature at 20 to 30°C and the current density at 2 to 5 A/dm², more desirably, 2 to 3 A/dm², and agitate the plating bath with air or a jet.

Even under the same electro copper plating conditions, the filling rate varies depending on the opening diameter (top diameter) of the laser-machined hole and the depth thereof (thickness of the insulation layer 10A). For example, in FIG. 15, let us suppose that electro copper plating is so performed that the thickness of the copper plating 11c will be 25μm. If the opening diameter of the laser-machined hole is 100μm and the thickness $T_2$ is 50μm, the filling rate 83% can be achieved. If the opening diameter of the laser-machined hole is 70μm and the thickness $T_2$ is 50μm, the filling rate 92% can be achieved. Regarding formation of a columnar conductor, it is to be noted that after the electro copper plating, the surface of the electro copper plating material which fills the laser-machined hole may be flattened, for example, by polishing or the like.

On the copper plating 11c of the intermediate material $B_6$ formed this way are performed patterning and etching to form a conductor circuit on the respective surfaces of the insulation layers 10A, 10B in a predetermined circuit pattern. Thus, the core substrate B according to the present invention shown in FIG. 8 is produced.

Next, how a multilayer circuit board is produced using this core substrate B will be described.

First, as shown in FIG. 16, on the upper surface 10a of the core substrate B, an insulation layer 10C of prepreg like the above-described prepreg and a copper foil 11a are laid in this order. Also on the lower surface 10b, an insulation layer 10D of prepreg and a copper foil 11b are laid. Then, the whole is hot-pressed to form an intermediate material $b_1$.

Next, in those parts of the intermediate material $b_1$ which are located right above the columnar conductor 13A and right below the columnar conductor 13B, openings are formed in the copper foils, holes are laser-machined, and desmearing, electroless copper plating and electro copper plating are performed in this order, in the manner explained with respect to the formation of the intermediate materials $B_4$, $B_5$, $B_6$ shown in FIGS. 12 to 14. Thus, an intermediate material $b_2$ as shown in FIG. 17 is formed.

In the intermediate material $b_2$, columnar conductors 13C, 13D as via-structures are formed in the newly laid unit circuit boards 10C, 10D, respectively, in the manner that the columnar conductors 13C, 13D are in direct contact with the columnar conductors 13A, 13B of the core substrate B, respectively. Thus, the intermediate material $b_2$ as a whole is a four-layer circuit board having a series via-structure.

If unit circuit boards are further laid on the upper and lower surfaces of the intermediate material $b_2$ in the same manner, a six-layer circuit board can be produced.

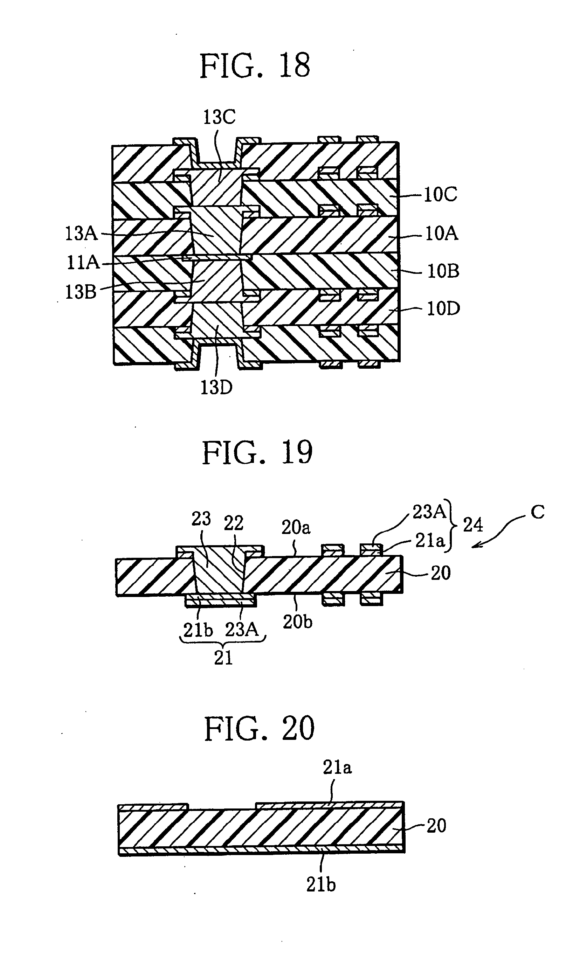

In that case, as shown in FIG. 18, a conformal via-structure may be formed in the uppermost unit circuit board in the manner that the conformal via-structure is in direct contact with the upper surface of the columnar conductor 13C, 13D.

Next, another core substrate C according to the present invention will be described.

As shown in FIG. 19, in the core substrate C, a conductor land part 21 consisting of a copper foil 21a and a copper plating 23A (described later) is formed on one 20b of the opposite surfaces of an insulation layer 20. A hole 22 extending from the other 20a of the opposite surfaces of the insulation layer 20 up to the conductor land part 21 is laser-machined in the insulation layer 20. A columnar conductor 23 is formed by filling the laser-machined hole 22 with an electro copper plating material. On each of the opposite surfaces 20a, 20b of the insulation layer 20, in the area where the columnar conductor 23 is not formed, a conductor circuit 24 having the same layer structure as the conductor land part 21 is formed in a predetermined pattern.

On the upper and lower surfaces of the core substrate C, a plurality of unit circuit boards are laid in successive layers to produce a multilayer circuit board. Thus, the produced multilayer circuit board has an even number of conductor circuit layers.

The core substrate C is produced as follows:

First, a double-sided copper-clad laminate is prepared. As shown in FIG. 20, an opening is formed in an upper copper foil 21a on an insulation layer 20 by performing patterning and etching on the surface of the upper copper foil 21a. Next, a hole 22 extending up to the upper surface of the lower copper foil 21b is formed by performing laser machining through the opening.

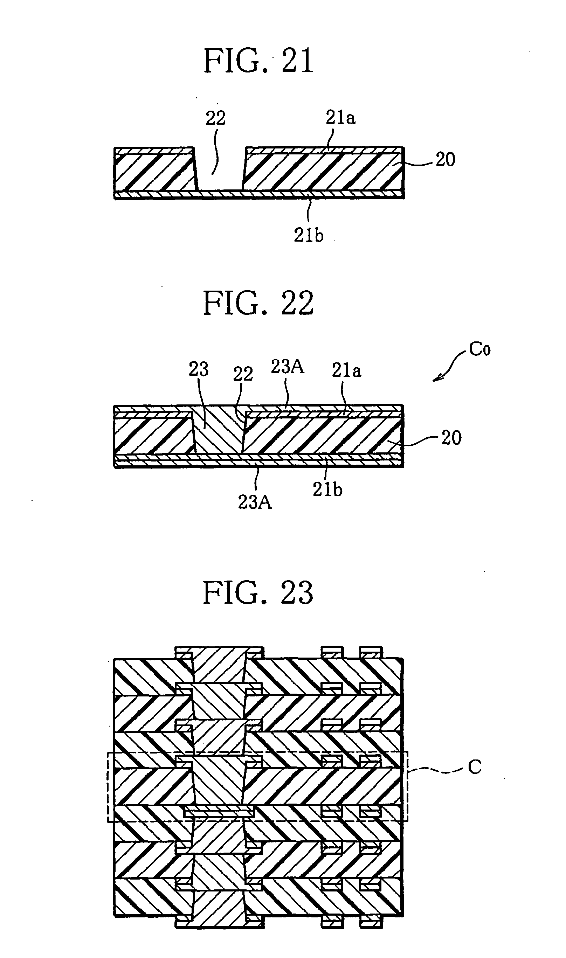

Next, the laser-machined hole 22 is filled with an electro copper plating material to form a columnar conductor 23, in the manner such that the intermediate material $B_6$ shown in FIG. 14 is formed. Thus, a precursor $C_0$ of the core substrate C as shown in FIG. 22 is formed.

Last, patterning and etching are performed on the opposite surfaces of the precursor $C_0$ to form a conductor land part 21 consisting of a copper foil 21b and a copper plating 23A laid thereon, and conductor circuits 24. Thus, the core substrate C shown in FIG. 19 is produced.

An example of a multilayer circuit board produced using this core substrate C is shown in FIG. 23.

This multilayer circuit board is produced by repeating, on both the upper and lower surfaces of the core substrate C, the process consisting of hot-pressing prepreg and copper foil, forming a conductor circuit and laser-machining a hole above a conductive circuit and a columnar conductor, filling the laser-machined hole with an electro copper plating material and forming a copper plating, and forming a conductor circuit and a via-structure by patterning and etching, in order, in the manner such that the intermediate materials $b_1$, $b_2$ shown in FIGS. 16 and 17 are formed.

Embodiments

Embodiment 1

(1) Production of a core substrate B

First, a double-sided copper-clad laminate B1 was prepared, where the thickness of copper foils 11a, 11b was 18μm, an insulation layer 10A was of FR-4 material, and the thickness of the insulation layer was 50μm

(FIG. 9).

Patterning was performed on the lower surface of the double-sided copper-clad laminate B1 using a dry film. Using a ferric chloride solution (Baume degree: 35, solution temperature: 50°C), etching was performed to thereby form an intermediate material $B_2$ having a conductor land part 11A of 250μm in diameter (FIG. 10).

Next, on that surface of the intermediate material $B_2$ on which the conductor land part was formed, prepreg (FR-4) 10B of 50μm in thickness and copper foil 11a of 18μm in thickness were laid, and hot-pressed with a vacuum press at 175°C and 2.9Mpa to thereby form an intermediate material $B_3$ (FIG. 11).

Next, patterning and etching like the above-described were performed on the opposite surfaces of the intermediate material $B_3$ to form openings 12b, 12a of 150μm in diameter in the copper foils 11b, 11a, right below and above the conductor land part 11A, respectively, to thereby form an intermediate material B, (FIG. 12).

Next, holes 12A, 12B of 100μm in diameter (top diameter) were laser-machined in the insulation layers 10A, 10B exposed in the openings in the copper foils , respectively, with a carbon dioxide laser beam machine, to form an intermediate material $B_5$ (FIG. 13).

Next, surface-roughening was performed using permanganic acid, and desmearing was performed on the surface of the conductor land part using Securigant P Process (name of a product by Atotech Japan K. K.). Then, electroless copper plating was performed, and then electro copper plating was performed under the conditions below, to thereby form an intermediate material $B_6$ shown in FIG. 14.

Bath composition: 200g/L of copper sulfate penta hydrate, 50g/L of sulfuric acid, 30mg/L of chlorine ion, 20mL/L of CUBELITE VF-II (name of a product by EBARA-UDYLITE CO., LTD.) A-agent and 1mL/L of CUBELITE VF-II B-agent.

Conditions: direct-current electrolysis at the current density of 2A/dm², at the bath temperature of 25°C, for the plating time of 90 minutes (plating thickness 25μm), with air agitation, with a positive electrode of phosphorous copper.

Next, patterning and etching like the above-described were performed on the intermediate material $B_6$ to form conductor circuits 14A, 14B, and the respective tops of the columnar conductors 13A, 13B were shaped into 250μm in diameter, to thereby form a core substrate B.

In the obtained core substrate B, the filling rate of the column conductors 13A, 13B was measured. It was 87%.

(2) Production of a multilayer circuit board

On the upper and lower surfaces of the core substrate B, prepreg (FR-4) of 50μm in thickness and copper foil of 18μm in thickness were laid, and hot-pressed with a vacuum press. Then, patterning and etching were performed on the copper foils to form conductor circuits and openings of 150µm in diameter right above the columnar conductors 13A, 13B.

Then, through these openings, holes of 100µm in opening diameter (top diameter) extending up to the upper surfaces of the columnar conductors 13A, 13B were laser-machined with a carbon dioxide laser beam machine. Then, electro copper plating was performed on the respective insides of the laser-machined holes, under the conditions mentioned above, to thereby form via-structures (columnar conductors).

The process above was repeated three times to thereby produce a multilayer circuit board having an eleven-layer structure as a whole. The produced multilayer circuit board included a series via-structure extending right above the columnar conductors 13A, 13B of the core substrate C, where the bottom of an upper via-structure is in direct contact with the top of a lower via-structure.

After normal resist printing and solder leveling were performed on this multilayer circuit board, a heat test was carried out, in which a cycle consisting of heat-treating the multilayer circuit board at 260°C for 10 seconds and leaving it at 20°C for 20 seconds was repeated 1000 times. The rate of change in value of overall resistance of the multilayer circuit board through the test was obtained. It was 2.8%.

Further, the multilayer circuit board was taken apart to examine whether there were abnormalities such as cracks. No abnormalities were found. Thus, it was established that the multilayer circuit board has high reliability.

Embodiment 2

Patterning and etching like those performed in embodiment 1 were performed on one of the opposite surfaces of the same double-sided copper-clad laminate $B_1$ as used in embodiment 1 to leave a copper foil part of 250µm in diameter. In the other of the opposite surfaces was formed an opening of 120µm in diameter.

Then, a hole of 70µm in opening diameter (top diameter) extending from the opening up to the copper foil part was laser-machined.

Then, surface-roughening and electroless copper plating like those performed in embodiment 1 were performed, and then electro copper plating was performed in the same way as in embodiment 1, except that the current density was 1.5A/dm$^2$ and the thickness of copper plating was 20µm, to thereby form a columnar conductor in the laser-machined hole. Thus, a core substrate C shown in FIG. 19 was produced. The filling rate of the columnar conductor was 93%, and the top thereof was practically flat.

On the upper and lower surfaces of the core substrate C, the laying of a unit circuit board as described in embodiment 1 was repeated twice to from a circuit board having a five-layer conductor-circuit structure.

The same heat test as in embodiment 1 was carried out on this circuit board. The rate of change in value of overall resistance was 3.1%, and no abnormalities such as cracks were found.

**INDUSTRIAL APPLICABILITY**

As is clear from the above explanation, compared with conventional multilayer circuit boards, a multilayer circuit board produced using a core substrate according to the invention has the following effects:

1) All layers are interconnected through a via-structure in which columnar conductors formed of an electroplating material are directly connected in series. Hence, the value of electrical resistance is very low, and the circuit board reliability is high.
2) In the via-structure, via-structures are laid in series. This enables high-density distribution of via-structures in one plane of the circuit board, and hence, enables fine patterning of conductor circuits.
3) Compared, for example, with the above-mentioned circuit board produced using conductive paste and that produced by forming a mountain-shaped bump (ALIVH (registered trademark) and B$^2$it™), the circuit board according to the present invention has advantages. First, the circuit board produced using conductive paste is high in electrical resistance, while the circuit board according to the invention produced by filling holes with an electroplating material is very low in electrical resistance. Second, when conductive paste is used to fill a via-hole or to form a mountain-shaped bump, a small-diameter via-hole or bump is difficult to form. According to the invention in which an electroplating material is used to fill a via-hole, a via-structure having a smaller diameter can be easily achieved. This enables a higher-density via-structure. Third, in the circuit board produced using conductive paste, the interlaminar connection is based on contact bonding. In the invention in which an electroplating material is used to fill a via-hole, the interlaminar connection is based on direct connection between metals, which provides high reliability against physical impact and heat.

**Claims**

1. A core substrate for being used in producing a multilayer circuit board in a manner that a plurality of unit circuit boards are laid on the upper and lower surfaces of said core substrate, comprising
   two insulation layers laid with a conductor land part between,
   said insulation layers having a pair of laser-machined holes above and below said conductor land part, each extending from the surface of the insulation layer up to said conductor land part, and

said pair of laser-machined holes being filled with an electroplating material to form a pair of columnar conductors electrically connected through said conductor land part.

2. A core substrate for being used in producing a multilayer circuit board in a manner that a plurality of unit circuit boards are laid on the upper and lower surfaces of said core substrate, comprising

an insulation layer with a conductor land part on one of the opposite surfaces thereof,

said insulation layer having a laser-machined hole extending from the other of the opposite surfaces of said insulation layer up to said conductor land part,

said laser-machined hole being filled with an electroplating material to form a columnar conductor, and

a conductor circuit being formed on each of the opposite surfaces of said insulation layer in an area where said columnar conductor is not formed.

3. A multilayer circuit board comprising:

a plurality of unit circuit boards laid in successive layers on the upper and lower surfaces of a core substrate according to claim 1 or 2, each of said unit circuit boards having a laser-machined hole located right above the columnar conductor of said core substrate, and all the laser-machined holes being filled with an electroplating material to form an alignment of via-structures where the lower surface of an upper via-structure is in contact with the upper surface of a lower via-structure.

4. A multilayer circuit board comprising

a plurality of unit circuit boards laid in successive layers on the upper and lower surfaces of a core substrate according to claim 1 or 2,

each of said unit circuit boards having a laser-machined hole located right above the columnar conductor of said core substrate,

all the laser-machined holes being filled with an electroplating material to form an alignment of via-structures where the lower surface of an upper via-structure is in contact with the upper surface of a lower via-structure, and

only the uppermost via-structure having an open wrinkle structure.

# FIG. 1

# FIG. 2

# FIG. 3

# FIG. 4

# FIG. 5

# FIG. 6

# FIG. 7

11

# FIG. 8

# FIG. 9

# FIG. 10

# FIG. 11

# FIG. 12

12a

B4

11b

10A

11A

10B

11a

12b

# FIG. 13

11A 12A

B5

11b

10A

10B

11a

11B

# FIG. 14

13A 12A

B6

11c

11b

10A

11A

10B

11a

11c

13B 12B

# FIG. 15

# FIG. 16

# FIG. 17

# FIG. 18

13C

13A

11A

13B

10C

10A

10B

10D

13D

# FIG. 19

23  22  20a

23A
21a  } 24  C

20

21b  23A
21    20b

# FIG. 20

21a

20

21b

# FIG. 21

# FIG. 22

# FIG. 23

## INTERNATIONAL SEARCH REPORT

International application No.

PCT/JP01/08860

### A. CLASSIFICATION OF SUBJECT MATTER
Int.Cl⁷    H05K3/46

According to International Patent Classification (IPC) or to both national classification and IPC

### B. FIELDS SEARCHED

Minimum documentation searched (classification system followed by classification symbols)
Int.Cl⁷    H05K3/46

Documentation searched other than minimum documentation to the extent that such documents are included in the fields searched
Jitsuyo Shinan Koho          1926-1996    Jitsuyo Shinan Toroku Koho    1996-2002
Kokai Jitsuyo Shinan Koho    1971-2002    Toroku Jitsuyo Shinan Koho    1994-2002

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 11-261236 A (Elna Co., Ltd.),<br>24 September, 1999 (24.09.1999)    (Family: none) | 1-4 |
| Y | JP 11-274731 A (Fujitsu Limited),<br>08 October, 1999 (08.10.1999)    (Family: none) | 1-4 |
| Y | JP 2000-323841 A (Meikoo K.K.),<br>24 November, 2000 (24.11.2000)    (Family: none) | 3,4 |
| Y | JP 2000-277912 A (Clover Denshi Kogyo K.K.),<br>06 October, 2000 (06.10.2000)    (Family: none) | 4 |
| A | JP 2000-101244 A (International Business Machines Corp.),<br>07 April, 2000 (07.04.2000)    (Family: none) | 1,3,4 |

☐  Further documents are listed in the continuation of Box C.          ☐  See patent family annex.

| | |
|---|---|
| *    Special categories of cited documents:<br>"A"    document defining the general state of the art which is not considered to be of particular relevance<br>"E"    earlier document but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search<br>07 January, 2002 (07.01.02) | Date of mailing of the international search report<br>22 January, 2002 (22.01.02) |
|---|---|
| Name and mailing address of the ISA/<br>    Japanese Patent Office | Authorized officer |
| Facsimile No. | Telephone No. |

Form PCT/ISA/210 (second sheet) (July 1992)